# EUROPEAN PATENT APPLICATION

(11) **EP 2 363 374 A2**
(43) Date of publication of application: **07.09.2011**
(21) Application number: 11156692.3
(22) Date of filing: 02.03.2011
(51) Int. Cl.: B81C 1/00

(54) **Manufacturing Method of MEMS Package, and Oscillator**

(30) Priority: 05.03.2010 JP 2010049878
(71) Applicant: Seiko Instruments Inc., Chiba-shi, Chiba (JP)
(72) Inventor: Yoshida, Yoshifumi, Chiba-shi, Chiba (JP)
(74) Representative: Cloughley, Peter Andrew

(57) **Abstract**

An electronic device package manufacturing method includes: forming a metal film on both surfaces of the cover substrate so that the metal film on one surface and the metal surface on the other surface conduct with each other; aligning and superimposing the cover substrate and the base substrate; and bonding the base substrate and the cover substrate together via the metal film by anodic bonding by bringing a negative electrode plate into contact with the base substrate on an entire surface opposite to a surface bonded to the cover substrate, bringing a positive electrode plate into contact with the cover substrate on an entire surface opposite to a surface bonded to the base substrate, and applying a voltage between the positive and negative electrode plates. The base substrate and the cover substrates can be thus bonded together via the metal film by anodic bonding in a stable manner.

## Description

The present invention relates to a package for a surface mount device (SMD) in which an electronic device is encapsulated in a cavity formed between two substrates bonded together, and more particularly, to a structure to bond two substrates by anodic bonding.

Recently, electronic devices using a compact surface mount device package are employed often in mobile phones and personal digital assistants. Of these electronic devices, many components, such as a transducer, an MEMS, a gyrosensor, and an acceleration sensor, require a package of a hollow cavity structure. A structure in which an insulator base substrate and an insulator cover substrate are bonded together via a metal film is known as a package of the hollow cavity structure. Also, eutectic bonding, seam bonding, and anodic bonding are known as a bonding method. Details are described, for example, in JP-A-09-002845.

A manufacturing method of a package in the related art in which an insulator base substrate and an insulator cover substrate are bonded together via a metal film by anodic bonding will now be described. In particular, a description will be given to a manufacturing method by which a plurality of package elements are formed in array on a single sheet of base substrate and after a cover substrate is bonded to the base substrate, the bonded substrates are divided into individual packages.

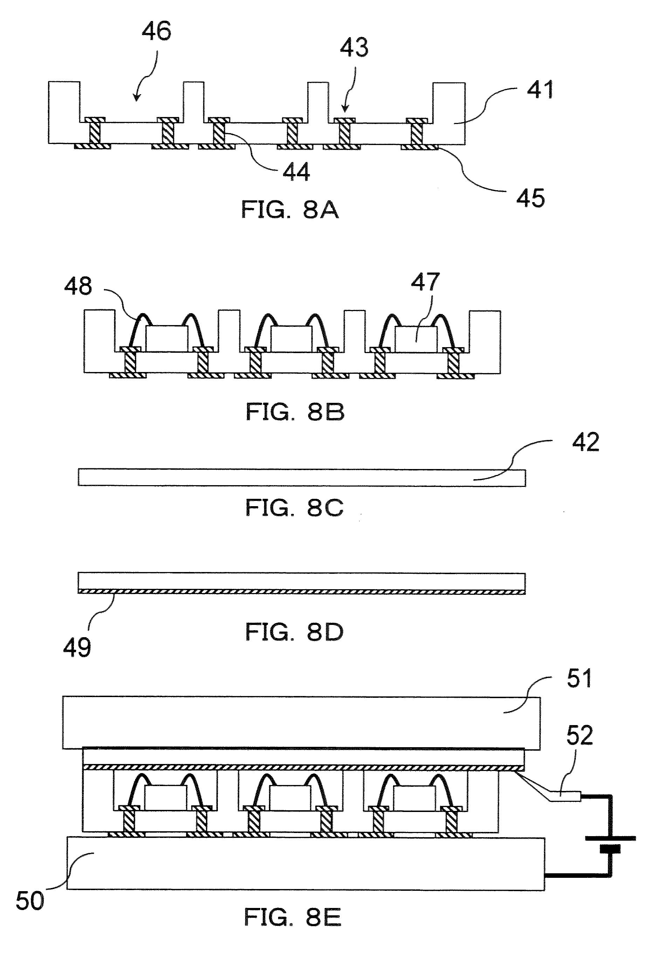

As are shown in Fig. 8A through Fig. 8E, an electronic device package in the related art includes an electronic device 47, a base substrate 41 provided with a concave portion, a plate-shaped cover substrate 42, and a metal film 49, which is a bonding film to bond the base substrate 41 and the cover substrate 42 together. Because the base substrate 41 is provided with a concave portion, a cavity 46 is formed by sealing the base substrate 41 with the cover substrate 42. The electronic device 47 is accommodated in the cavity 46.

The base substrate 41 is formed of an insulator containing movable ions, for example, a glass material, and formed to have concave portions. Wires 43 used to mount the electronic devices 47 are formed on the surface of the base substrate 41 in a number according to the number of the electronic devices 47 to be mounted. Outside electrodes 45 are formed on the back surface of the base substrate 41 in a corresponding manner to the wires 43. In order to connect the wires 43 on the front surface of the base substrate 41 and the corresponding outside electrodes 45 on the back surface, through-holes are formed at arbitrary portions of the packages and feed-through electrodes 44 are formed to fill the respective through-holes. The wires 43 and the outside electrodes 45 are thus connected via the feed-through electrodes 44.

As with the base substrate 41, the cover substrate 42 is formed of an insulator containing movable ions, such as a glass material and formed in a plate shape. When the cavities 46 are formed as the base substrate 41 and the cover substrate 42 are bonded together, the metal film 49 is formed as the bonding film in a portion where the base substrate 41 and the cover substrate 42 come into contact with each other. Basically, it is sufficient to form the metal film 49 only on the portion where the base substrate 41 and the cover substrate 42 come into contact with each other. However, by taking simplification of the steps into account, as is shown in Fig. 8D, the metal film 49 is formed entirely on one surface of the cover substrate 42.

The manufacturing method will now be described. A plurality of concave cavities 46 are formed in a wafer of base substrate 41 so that a plurality of electronic devices 47 can be mounted thereon. Thereafter, the wires 43 used to mount the electronic devices 47, the outside electrodes 45, and the feed-through electrodes 44 are formed (Fig. 8A). Subsequently, the electronic devices 47 are mounted in the cavities 46 and the electronic devices 47 and the wires 43 are connected with wires 48 by wire bonding (Fig. 8B). On one surface of the plate-shaped cover substrate 42 (Fig. 8C), the metal film 49 as a bonding film is formed (Fig. 8D). Aluminum, chrome, silicon, and copper are suitable as the metal film.

The base substrate 41 and the cover substrate 42 are aligned and superimposed, and then bonded together by anodic bonding. When bonded together by anodic bonding, as is shown in Fig. 8E, the base substrate 41 and the cover substrate 42 aligned with each other are sandwiched by substrates 50 and 51 serving as heaters and also as electrodes. A positive electrode probe 52 is set so as to come into contact with the metal film 49 and temperatures of the substrates 50 and 51 serving as heaters and electrodes are raised. A voltage is then applied between the positive electrode probe 52 and the substrate 50 serving as a heater and an electrode. Consequently, the base substrate 41 and the cover substrate 42 are bonded together via the metal film 49. Thereafter, package elements are cut off individually using a dicing apparatus or the like. Individual electronic device packages are thus completed.

The manufacturing method of the electronic device package in the related art, however, has problems as follows. Firstly, the positive electrode probe 52 is brought into contact with a part of the metal film 49, which is a bonding film, when anodic bonding is performed. In this instance, in a case where the metal film 49 has high sheet resistance, it is difficult to maintain the entire surface of the cover substrate 42, which is a wafer, at the same potential. This poses a problem that bonding strength varies within the wafer plane. As a countermeasure to lower the sheet resistance, the resistance value is decreased by making the metal film 49 thicker. However, when the metal film 49 becomes thicker, bonding strength between the metal film 49 and the base substrate 41 becomes lower. Further, because the metal film 49 is formed on one surface of the cover substrate 42, when the metal film 49 becomes thicker, there arises another problem that the cover substrate 42 warps.

In addition, in order to bring the positive electrode probe 52 into contact with a part of the metal film 49, as is shown in Fig. 8E, it becomes necessary to displace the base substrate 41 and the cover substrate 42 from each other for the positive electrode probe 52 to come into contact with a part of the metal film 49. This poses another problem that alignment of the base substrate 41 and the cover substrate 42 is limited strictly. In particular, in the case of a package in which a pattern is formed on the cover substrate 42, there is a problem that the limitation on alignment gives considerable influences to the number of products taken out from the wafer.

The invention was devised in view of the foregoing and has an object to provide a manufacturing method of an electronic device package capable of bonding an insulator base substrate and an insulator cover substrate together via a metal film by anodic bonding in a stable manner.

A manufacturing method of an electronic device package according to an aspect of the invention is a manufacturing method of an electronic device package including a base substrate formed of an insulator containing movable ions, a cover substrate formed of an insulator containing movable ions and bonded to the base substrate while being opposed to the base substrate, and electronic devices respectively accommodated in a plurality of cavities formed between the base substrate and the cover substrate and mounted on the base substrate. The manufacturing method includes: forming a metal film on both surfaces of the cover substrate so that the metal film on one surface and the metal surface on the other surface conduct with each other; aligning and superimposing the cover substrate and the base substrate; and bonding the base substrate and the cover substrate together via the metal film by anodic bonding by bringing one electrode plate into contact with the base substrate on a surface opposite to a surface bonded to the cover substrate, bringing the other electrode plate into contact with the cover substrate on a surface opposite to a surface bonded to the base substrate, and applying a voltage between the one electrode plate and the other electrode plate.

According to the manufacturing method of an electronic device package of the invention, the metal film is formed on the both surfaces of a wafer from which the cover substrate is formed in such a manner that the metal film on one surface and the metal film on the other surface conduct with each other. It thus becomes possible to bring the electrode plate into contact with the cover substrate on the surface opposite to the surface bonded to the base substrate. Accordingly, there can be achieved an advantage that potential in the bonding portion can be maintained in a reliable manner. The invention is particularly effective when metal having high sheet resistance is used as a material of the metal film or an extremely thin metal film is used. In addition, in a case where metal having high sheet resistance is used as a material of the metal film, the need to make the metal film thicker is eliminated. This makes it possible to prevent warping of the cover substrate caused by the metal film. Hence, there can be achieved an advantage that alignment accuracy of the base substrate and the cover substrate is enhanced. Moreover, because the electrode plate can be brought into contact with the cover substrate on the surface opposite to the surface bonded to the base substrate, the alignment of the base substrate and the cover substrate is no longer limited strictly.

Further, by bringing the electrode plate into contact with the cover substrate on the entire surface opposite to the surface bonded to the base substrate during anodic bonding, not only does it become possible to achieve an advantage of the metal film covering the cover surface, but it also becomes possible to achieve an advantage of interchange of charges that depends on the capacity of the cover substrate, which is an insulator. Consequently, an amount of charges migrating during anodic bonding is increased. This results in an advantage that further higher bonding strength can be obtained.

Preferably, the one electrode plate is brought into contact with the base substrate on the entire surface opposite to the surface bonded to the cover substrate and the other electrode plate is brought into contact with the cover substrate on the entire surface opposite to the surface bonded to the base substrate.

Preferably, the metal film is made of one of aluminum, chrome, silicon, copper, and a combination thereof.

Preferably, a film thickness of the metal film is set to a range of 200 angstroms to 2000 angstroms.

According to another aspect of the present invention, there is provided an electronic device package, comprising:
a base substrate formed of an insulator containing movable ions;
a cover substrate formed of an insulator containing movable ions and having a metal film formed on both surfaces, the cover substrate forming a cavity with the base substrate in between when bonded to the base substrate by anodic bonding while being opposed to the base substrate; and
an electronic device accommodated in the cavity and mounted on the base substrate.

According to a further aspect of the present invention, there is provided an oscillator, comprising:
the electronic device package set out above and having a piezoelectric vibrating piece as the electronic device; and
an integrated circuit electrically connected to the electronic device package as a transducer.

Embodiments of the present invention will now be described by way of further example only and with reference to the accompanying drawings, in which:
Fig. 1 is a perspective view showing one embodiment of an electronic device package of the invention;
Fig. 2 is a cross section showing one embodiment of the electronic device package of the invention;
Fig. 3 is a flowchart depicting one embodiment of a manufacturing method of the electronic device package of the invention;
Fig. 4A through Fig. 4E are cross sections depicting one embodiment of the manufacturing method of the electronic device package of the invention;
Fig. 5A and Fig. 5B are cross sections depicting one embodiment of the manufacturing method of the electronic device package of the invention;
Fig. 6 is a cross section showing another embodiment of the electronic device package of the invention;
Fig. 7 is a view showing one embodiment of an oscillator of the invention; and
Fig. 8A through Fig. 8E are cross sections depicting a manufacturing method of an electronic device package in the related art.

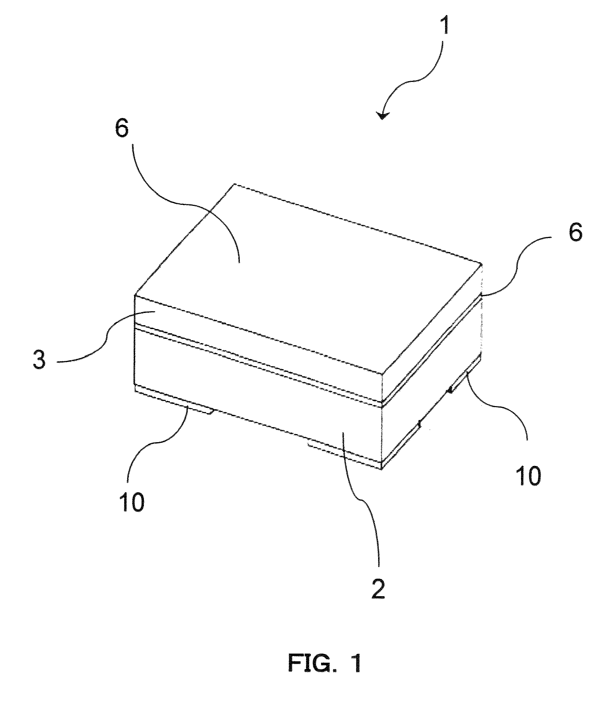

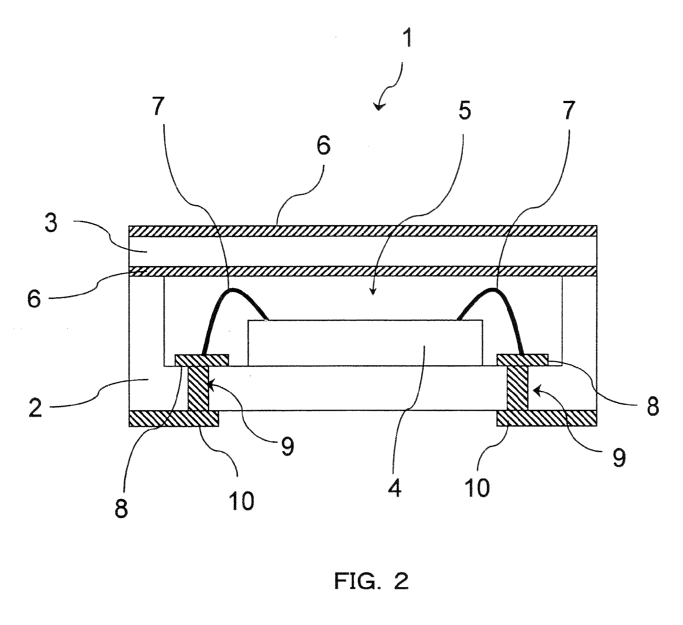

Hereinafter, one embodiment of the invention will be described with reference to Fig. 1 through Fig. 5B. As are shown in Fig. 1 and Fig. 2, an electronic device package 1 of this embodiment is a surface mount device package including a base substrate 2 and a cover substrate 3 laminated in two layers in a box shape and an electronic device 4 accommodated in a cavity 5 formed inside the box. The electronic device 4 may be an LSI, an MEMS, a sensor, and a piezoelectric transducer, or a complex thereof.

Both the base substrate 2 and the cover substrate 3 are insulators containing movable ions, for example, insulating substrates made of soda-lime glass. In the case shown in Fig. 1 and Fig. 2, a rectangular concave portion (cavity) 5 large enough to accommodate the electronic device 4 is formed in the base substrate 2 and the cover substrate 3 is formed in a plate shape. The concave portion 5 is a concave portion that later forms the cavity 5 in which to accommodate the electronic device 4 when the both substrates 2 and 3 are superimposed. The base substrate 2 is bonded to the cover substrate 3 by anodic bonding via the metal film 6, which is a bonding film, in a state where the concave portion 5 is opposed to the cover substrate 3.

As is shown in Fig. 2, feed-through electrodes 9 are formed in the base substrate 2 to electrically connect the electronic device 4 and outside electrodes 10. Through-holes in which to insert the feed-through electrodes 9 are formed to open within the cavity 5. With reference to Fig. 2, descriptions will be given to through-holes that penetrate straight through the base substrate 2 while maintaining substantially a constant diameter. The invention, however, is not limited to this case. For example, through-holes may be tapered by gradually increasing or decreasing the diameter toward the bottom surface of the base substrate 2. In any case, it is sufficient that through-holes penetrate through the base substrate 2.

The feed-through electrodes 9 are formed in the respective through-holes so as to fill the through-holes. The feed-through electrodes 9 play not only a role of maintaining the interior of the cavity 5 hermetically by completely closing the through-holes but also a role of bringing the outside electrodes 10 and the electric device 4 into conduction. A clearance between the through-hole and the feed-through electrode 9 is completely filled using a glass frit material having a thermal expansion coefficient adjusted to that of the glass material of the base substrate 2.

In this embodiment, a clearance between the through-hole and the feed-through electrode 9 is filled with a glass frit material. However, the invention is not limited to this configuration and a conductive adhesive and a resin-based filling material are also available. A conductive adhesive and a resin-based filling material, however, deteriorate with time or cause the generation of outgas. Hence, from the viewpoint of reliability over a long term, a glass frit material or a glass material per se is desirable to fill a clearance between the through-hole and the feed-through electrode 9.

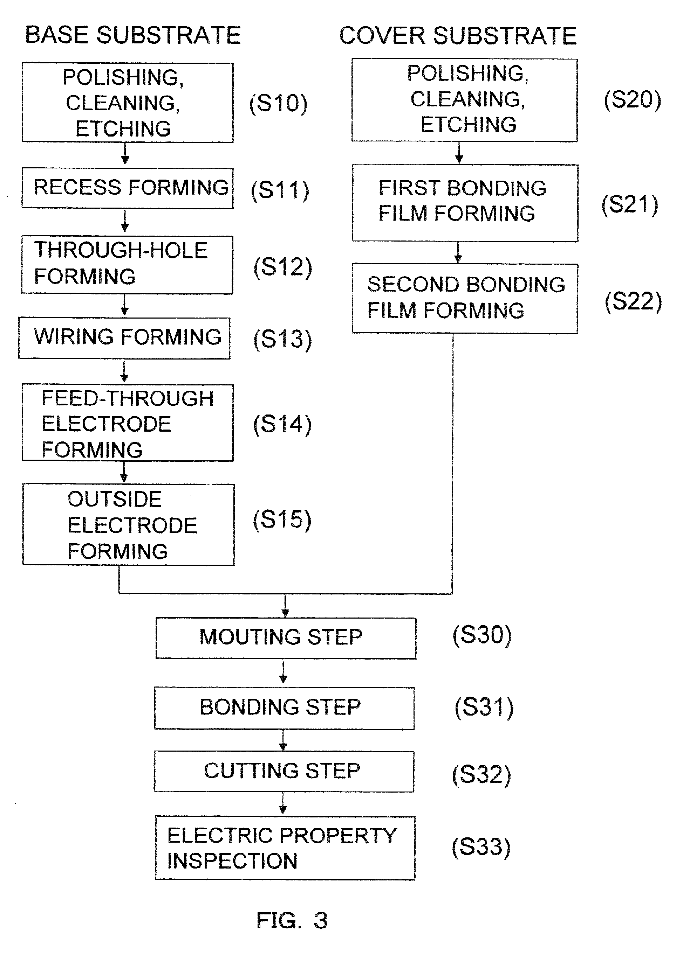

A manufacturing method of an electronic device package according to one embodiment of the invention will now be described with reference to the flowchart of Fig. 3 and Fig. 4A through Fig. 5B.

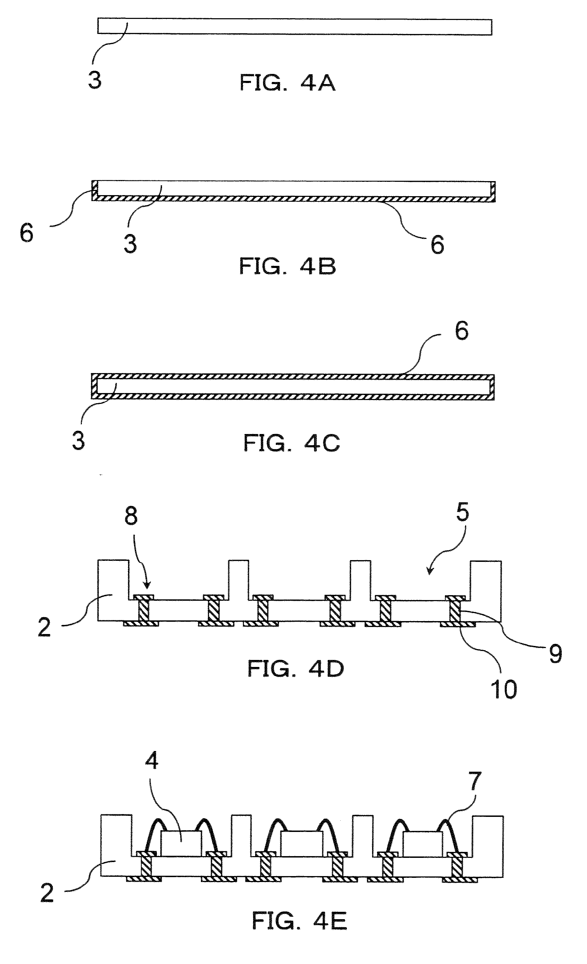

Initially, the base substrate 2 is obtained by polishing and etching a wafer of insulating substrate until it reaches a target thickness followed by rinsing (S10). Subsequently, concave portions that later form the cavities 5 are formed in the base substrate 2, which is a plate-shaped insulator (S11). The concave portions can be formed by any appropriate method and etching by photolithography and press working are applicable. Subsequently, through-holes are formed in the bottoms of the cavities 5. The through-holes can also be formed by any appropriate method and etching by photolithography and press working are applicable (S12). Wires 8 used to mount the electronic devices 4 on the bottom surfaces of the cavities 5 are formed (S13). Subsequently, the feed-through electrodes 9 are formed in the through-holes formed in the bottoms of the cavities 5 (S14). Further, the outside electrodes 10 are formed on the surface of the base substrate 2 opposite to the bottom surfaces of the cavities 5 (S15). Fig. 4D shows the base substrate 2 in a state where the outside electrodes 10 have been formed.

Meanwhile, the cover substrate 3 is obtained by polishing and etching a wafer of insulating substrate until it reaches a target thickness followed by rinsing (S20). Subsequently, as is shown in Fig. 4B, the metal film 6 as a bonding film is formed on the entire one surface of the plate-shaped cover substrate 3 and on the side surfaces of the cover substrate 3 in the thickness direction (S21). It may also be formed on the side surfaces at this stage. Herein, the metal film 6 is formed using methods, such as vapor deposition, sputtering, and CVD. Also, Al, Si, and Cr are used for the metal film 6 and a thickness thereof is set to a range of 200 angstroms to 2000 angstroms. Subsequently, as is shown in Fig. 4C, the metal film 6 as a bonding film is formed on the entire other surface of the cover substrate 3 and on the side surfaces of the cover substrate 3 in the thickness direction (S22). Again, the metal film 6 is formed using methods, such as vapor deposition, sputtering, and CVD. Also, Al, Si, and Cr are used for the metal film 6 and a thickness thereof is set to a range of 200 angstroms to 2000 angstroms. Consequently, the metal film 6 is formed entirely on both the front and back surfaces of the cover substrate 3 and the metal film 6 on the front surface and the metal film 6 on the back surface conduct with each other via the metal film 6 formed on the entire side surfaces of the cover substrate 3. In short, the substrate 3 is covered with the metal film 6. However, although preferred, it is not necessary to cover the entire side surfaces or the entire front and back surfaces of the cover substrate 3.

As is shown in Fig. 4E, the electronic devices 4 are accommodated in the cavities 5 of the base substrate 2 and mounted on the base substrate 2 (S30). Fig. 4E shows a case where the wires 8 and the electronic devices 4 are connected by wire bonding using wires 7. The invention, however, is not limited to this connection method. As long as electric conduction is ensured, any connection method, such as flip chip bonding and solder bonding, is applicable.

The film thickness of the metal film 6 is limited to the range of 200 angstroms to 2000 angstroms because of a relation with stability in film formation and bonding strength. When the film thickness is 200 angstroms or less, adhesion strength between the insulator and the metal film 6 is weak. Hence, in order to ensure bonding strength, a film thickness of 200 angstroms or more is strongly preferable. Meanwhile, when the film thickness is 2000 angstroms or more, bonding strength becomes dependent on an intermolecular bonding force of the film. This reduces an advantage of anodic bonding.

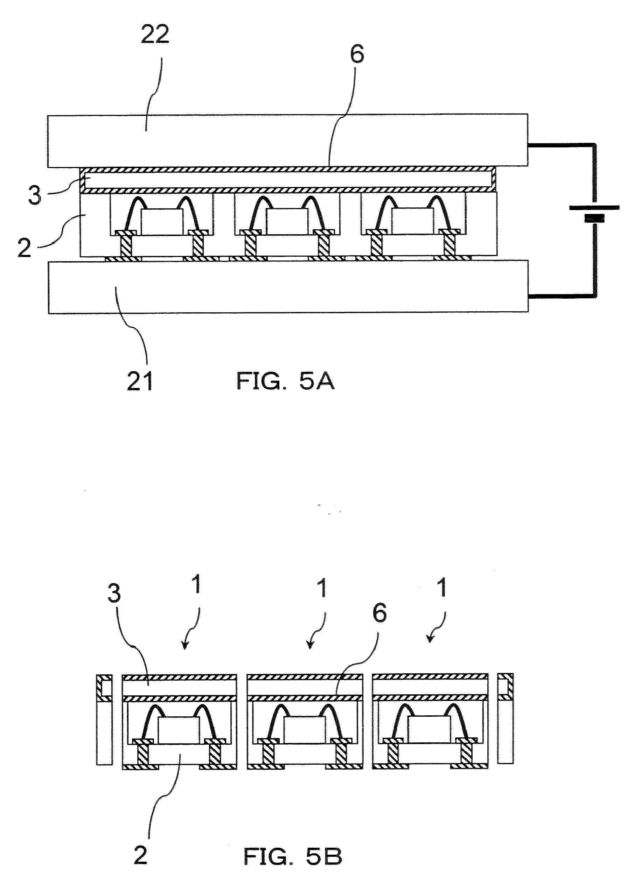

Subsequently, as is shown in Fig. 5A, the base substrate 2, on which are mounted the electronic devices 4, and the cover substrate 3, on which is formed the metal film 6, are bonded together via the metal film 6 by anodic bonding (S31). In the case shown in Fig. 4A through Fig. 5B, the base substrate 2 is formed in an adequate size to be superimposed on the cover substrate 3.

When anodic bonding is performed, the cover substrate 3 and the base substrate 2 are aligned and superimposed first. Subsequently, a negative electrode plate 21 made of carbon or the like is brought into contact with the base substrate 2 on the entire surface opposite to the surface bonded to the cover substrate 3. A positive electrode plate 22 made of carbon or the like is brought into contact with the cover substrate 3 on the entire surface opposite to the surface bonded to the base substrate 2. Further, a certain load is applied between the positive electrode plate 22 and the negative electrode plate 21. In this state, the positive electrode plate 22, the negative electrode plate 21, the base substrate 2, and the cover substrate 3 are heated to 200 to 300°C by a heater or the like and a voltage of 500 to 1000 V is applied between the positive electrode plate 22 and the negative electrode plate 21. The base substrate 2 and the cover substrate 3 are thus bonded together by anodic bonding.

In this state, a plurality of electronic device package elements are present in a single wafer obtained by bonding a wafer of base substrate 2 and a wafer of cover substrate 3. Accordingly, as is shown in Fig. 5B, the electronic device packages 1 are cut off individually using a dicing saw or a wire saw (S32). Fig. 2 shows a cross section of one individually cut-off electronic device package 1. In the individually cut-off electronic device package 1, the metal film 6 is not formed on the side surfaces of the cover substrate 3 in the thickness direction. The reason why is as follows. That is, the bonding film is formed on the entire side surfaces of the cover substrate 3 in the thickness direction in the outermost circumference portion in a state of a wafer before the electronic device packages 1 are cut off individually. Accordingly, the metal film 6 on the bonding surface of the cover substrate 3 bonded to the base substrate 2 and the metal film 6 on the surface opposite to the boding surface are connected on the side surfaces in the circumference portion. This configuration makes it possible to fix the potential of the metal film 6 and allows charges to migrate smoothly during anodic bonding. However, after the anodic bonding ends, the metal film 6 on the side surfaces of the cover substrate 3 in the thickness direction is no longer necessary. Hence, in the individually cut-off electronic device package 1, the metal film 6 is not formed on the side surfaces of the cover substrate 3 in the thickness direction. In other words, in the individually cut-off electronic device package 1, the metal film 6 formed entirely on one surface of the cover substrate 3 and the metal film 6 formed entirely on the other surface do not conduct with each other. Thereafter, the electronic device package 1 is completed by conducting an inspection on the internal electric property (S33).

An advantage of bonding the base substrate 2 and the cover substrate 3 together by anodic bonding will now be described. In a case where a ceramic substrate is used as the base substrate, it is necessary to bond a cover for each individual electronic device. Accordingly, a large pressure is applied to the base substrate when the cover is bonded to the base substrate. When the width of the bonding surface is narrow, the bonding surface cannot withstand the pressure. This causes a problem that cracking or chipping occurs. On the contrary, because the electronic device package 1 of this embodiment uses anodic bonding to bond the base substrate 2 and the cover substrate 3 together, a plurality of the electronic devices 4 can be mounted simultaneously. Accordingly, a pressure applied to the base substrate per package at the time of bonding becomes small and even when the bonding surface is small, no cracking or chipping occurs. Anodic bonding is therefore extremely effective in manufacturing a compact package.

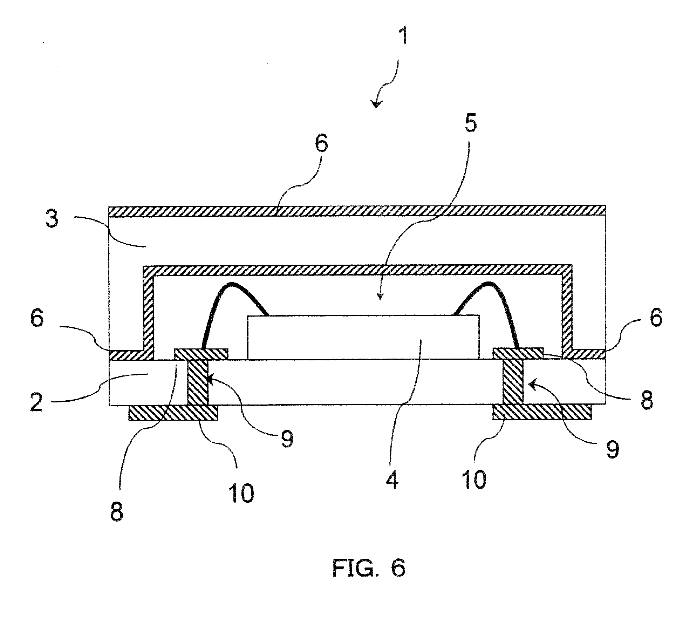

It should be appreciated that the scope of the invention is not limited to the embodiment described above and various modifications can be made without deviating from the scope of the invention. In the embodiment described above, concave portions of a rectangular shape that later form the cavities 5 in which to accommodate the electronic devices 4 are formed in the base substrate 2 on the bonding surface to which the cover substrate 3 is bonded. The invention, however, is not limited to this configuration. For example, as is shown in Fig. 6, concave portions of a rectangular shape that later form the cavities 5 in which to accommodate the electronic devices 4 may be formed in the cover substrate 3 on the bonding surface to which the base substrate 2 is bonded. In a case where the cavities 5 are formed in the base substrate 2, it is difficult to form the wires 8 used to mount the electronic devices 4 on the base substrate 2 in some cases. In such a case, the wires 8 can be formed more easily by forming the cavities 5 in the cover substrate 3 as is shown in Fig. 6.

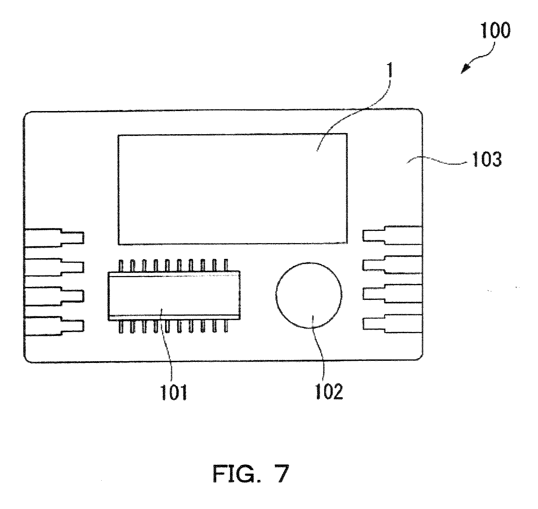

One embodiment of an oscillator of the invention will now be described with reference to Fig. 7. As is shown in Fig. 7, an oscillator 100 of this embodiment includes, as a transducer electrically connected to an integrated circuit 101, the electronic device package 1 (piezoelectric transducer) using a piezoelectric vibrating piece made, for example, of quartz, as the electronic device 4. The oscillator 100 includes a substrate 103 on which an electronic component 102, such as a capacitor, is mounted. The integrated circuit 101 for oscillator is mounted on the substrate 103 and the electronic device package 1 (piezoelectric transducer) is mounted thereon in the vicinity of the integrated circuit 101. The electronic component 102, the integrated circuit 101, and the electronic device package 1 (piezoelectric transducer) are electrically interconnected by an unillustrated wiring pattern. Each component is molded with unillustrated resin.

In the oscillator 100 configured as above, when a voltage is applied to the piezoelectric transducer, the piezoelectric vibrating piece in the piezoelectric transducer vibrates. The vibration is converted to an electric signal by the piezoelectric characteristic of the piezoelectric vibrating piece and inputted into the integrated circuit 101 as the electric signal. The integrated circuit 101 applies various types of processing to the electric signal inputted therein and outputs the resulting signal as a frequency signal. The piezoelectric transducer thus functions as an oscillator. By selectively setting the configuration of the integrated circuit 101 as required, for example, by setting an RTC (Real Time Clock) module, it becomes possible to provide a single-function oscillator for timepiece with an additional function of controlling an operation date or clock time of the oscillator or an outside device or presenting a clock time or a calendar.

The foregoing description has been given by way of example only and it will be appreciated by a person skilled in the art that modifications can be made without departing from the scope of the present invention.

## Claims

1. A manufacturing method of an electronic device package (1) including a base substrate (2) formed of an insulator containing movable ions, a cover substrate (3) formed of an insulator containing movable ions and bonded to the base substrate while being opposed to the base substrate, and electronic devices (4) respectively accommodated in a plurality of cavities (5) formed between the base substrate and the cover substrate and mounted on the base substrate, the manufacturing method comprising:
forming (S21, S22) a metal film (6) on both surfaces of the cover substrate so that the metal film on one surface and the metal surface on the other surface conduct with each other;
aligning and superimposing (S30) the cover substrate and the base substrate; and
bonding (S31) the base substrate and the cover substrate together via the metal film by anodic bonding by bringing one of positive and negative electrode plates (21, 22) into contact with the base substrate on a surface opposite to a surface bonded to the cover substrate, bringing the other electrode plate (22, 21) into contact with the cover substrate on a surface opposite to a surface bonded to the base substrate, and applying a voltage between the positive electrode plate and the negative electrode plate.

2. The manufacturing method of an electronic device package according to claim 1, wherein:
the one electrode plate (21) is brought into contact with the base substrate (2) on the entire surface opposite to the surface bonded to the cover substrate (3) and the other electrode plate (22) is brought into contact with the cover substrate (3) on the entire surface opposite to the surface bonded to the base substrate (2).

3. The manufacturing method of an electronic device package according to claim 1 or claim 2, wherein:
the metal film (6) is made of one of aluminum, chrome, silicon, copper, and a combination thereof.

4. The manufacturing method of an electronic device package according to any one of the preceding claims, wherein:
a film thickness (6) of the metal film is set to a range of 200 angstroms to 2000 angstroms.

5. An electronic device package (1), comprising:
a base substrate (2) formed of an insulator containing movable ions;
a cover substrate (3) formed of an insulator containing movable ions and having a metal film (6) formed on both surfaces, the cover substrate forming a cavity (5) with the base substrate in between when bonded to the base substrate by anodic bonding while being opposed to the base substrate; and
an electronic device (4) accommodated in the cavity and mounted on the base substrate.

6. An oscillator (100), comprising:
the electronic device package (1) set forth in claim 5 and having a piezoelectric vibrating piece as the electronic device; and
an integrated circuit (101) electrically connected to the electronic device package as a transducer.
